(19)

Europäisches
Patentamt

European
Patent Office

Office européen
des brevets

(11) EP 2 475 019 A2

(12) EUROPEAN PATENT APPLICATION

(43) Date of publication:
**11.07.2012 Bulletin 2012/28**

(51) Int Cl.:
***H01L 35/30*** *(2006.01)*

(21) Application number: **11193897.3**

(22) Date of filing: **15.12.2011**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **15.12.2010 US 969407**

(71) Applicant: **The Boeing Company
Chicago, IL 60606-2016 (US)**

(72) Inventors:
• **Mitchell, Bradley J.
Snohomish, WA Washington 98296-8051 (US)**
• **Sanford, William C.
Mukilteo, WA Washington 98275-4110 (US)**

(74) Representative: **Howson, Richard G.B. et al
Kilburn & Strode LLP
20 Red Lion Street
London WC1R 4PJ (GB)**

(54) **Power generation using a thermoelectric generator and a phase change material**

(57)     An energy harvesting device is disclosed that includes a thermoelectric device adapted to produce electricity according to a Seebeck effect when a thermal gradient is imposed across first and second major surfaces thereof, a housing enclosing a phase change material that is disposed for thermal communication with the first major surface of the thermoelectric device, and a radio transmitter electrically coupled to the thermoelectric device, the radio transmitter capable of transmitting wireless signals. In another aspect, the housing includes a conductive fin therein to provide more uniform distribution of heat to the phase change material.

FIG. 1

**Description**

FIELD

This application relates to power generation using thermoelectric generators and, more particularly, to power generation using a thermoelectric generator and a phase change material.

BACKGROUND

Energy harvesting devices generate electrical power from energy sources that are often overlooked and untapped. Examples of energy sources and methods to convert electricity include photovoltaic devices which convert light energy into electricity, cantilevered piezoelectric beams which convert vibrational energy into electricity and thermoelectric devices which convert heat flow into electricity. These energy harvesting devices and methods are amenable to a variety of applications.

As low power electronics become increasingly prevalent, energy harvesting devices and methods provide a useful way to power electronic devices without the need for batteries or even electrical power wiring. Electrical wiring is undesirable in many applications due to its cost to design and install, as well as its weight and difficulty to retrofit. Batteries are undesirable on airplanes, for example, due to the difficulty of replacement and because some batteries pose environmental or safety hazards. Additionally, batteries may function poorly in low temperatures. In some cases, electronic devices that occasionally require medium quantities of electrical power may be powered using low-power energy harvesting devices. In these cases, electrical energy generated by energy harvesting devices is stored in a capacitor or rechargeable battery.

Thermoelectric generators are devices that utilize the physics principal known as the Seebeck effect discovered in 1821. If two conductors of different materials such as copper and iron are joined at their ends forming two junctions, and one junction is held at a higher temperature than the other junction, a voltage difference will arise between the two junctions. Various thermoelectric generators are commercially available. One such module is an HZ-2 from Hi-Z Corporation. The dimensions of the module are 1.15 inches x 1.15 inches x 0.20 inch, and the module comprises a 14x14 array of thermoelectric elements.

SUMMARY

In one aspect, an energy harvesting device is disclosed that includes a thermoelectric device adapted to produce electricity according to a Seebeck effect when a thermal gradient is imposed across first and second major surfaces thereof, a housing enclosing a phase change material that is disposed for thermal communication with the first major surface of the thermoelectric device for thermal communication between the phase change material and the thermoelectric device, and a radio transmitter electrically coupled to the thermoelectric device. The radio transmitter is capable of transmitting signals.

In another aspect, an energy harvesting device is disclosed that includes a thermoelectric device adapted to produce electricity according to a Seebeck effect when a thermal gradient is imposed across first and second major surfaces thereof, a housing enclosing a phase change material that is disposed for thermal communication with the first major surface of the thermoelectric device, and a conductive fin within the housing to provide more uniform distribution of heat within the phase change material.

Any of the embodiments disclosed herein for the energy harvesting devices may be mounted to a substrate that is part of a mobile device that experiences a temperature change as a result of its mobility.

The features, functions, and advantages that have been discussed can be achieved independently in various embodiments or may be combined in yet other embodiments, further details of which can be seen with reference to the following drawings and description.

BRIEF DESCRIPTION OF THE DRAWINGS

FIG. 1 is a perspective view of one embodiment of an energy harvesting device.
FIG. 2 is a perspective view of another embodiment of an energy harvesting device.
FIG. 3 is a top plan view of two embodiments of energy harvesting devices comparing the solid state build up within the devices.
FIG. 4 is a graph illustrating the difference in the temperatures T2 and T2' of the two devices of FIG. 3.
FIG. 5 illustrates the thermal circuit diagram for the energy harvesting devices of FIG. 3.

FIG. 6 is a top plan view of one embodiment of an energy harvesting device including a corresponding thermal circuit diagram.

FIG. 7 is a top plan view of an alternate embodiment of an energy harvesting device.

DESCRIPTION

The following detailed description will illustrate the general principles of the invention, examples of which are additionally illustrated in the accompanying drawings. In the drawings, like reference numbers indicate identical or functionally similar elements.

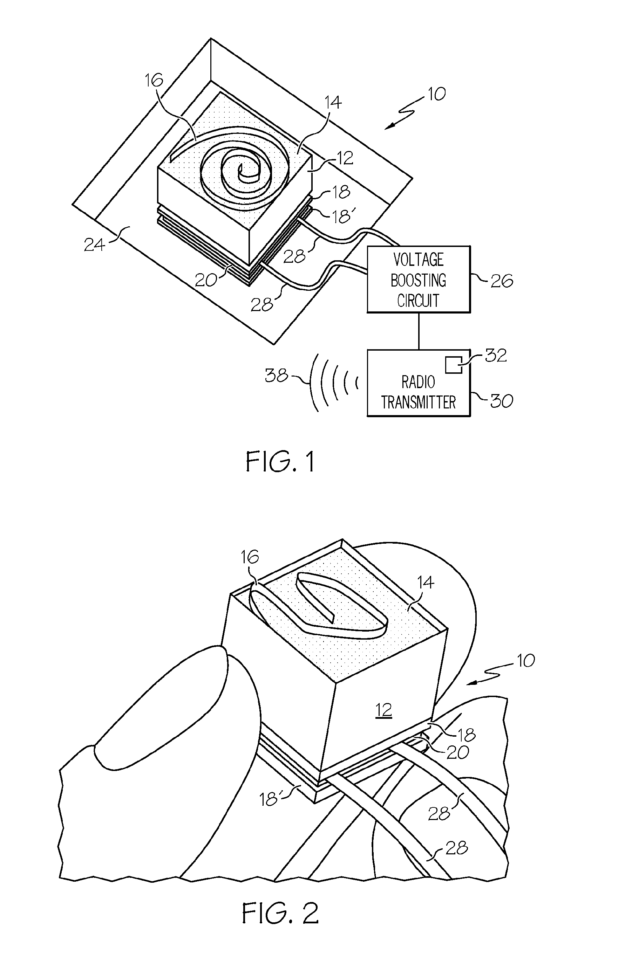

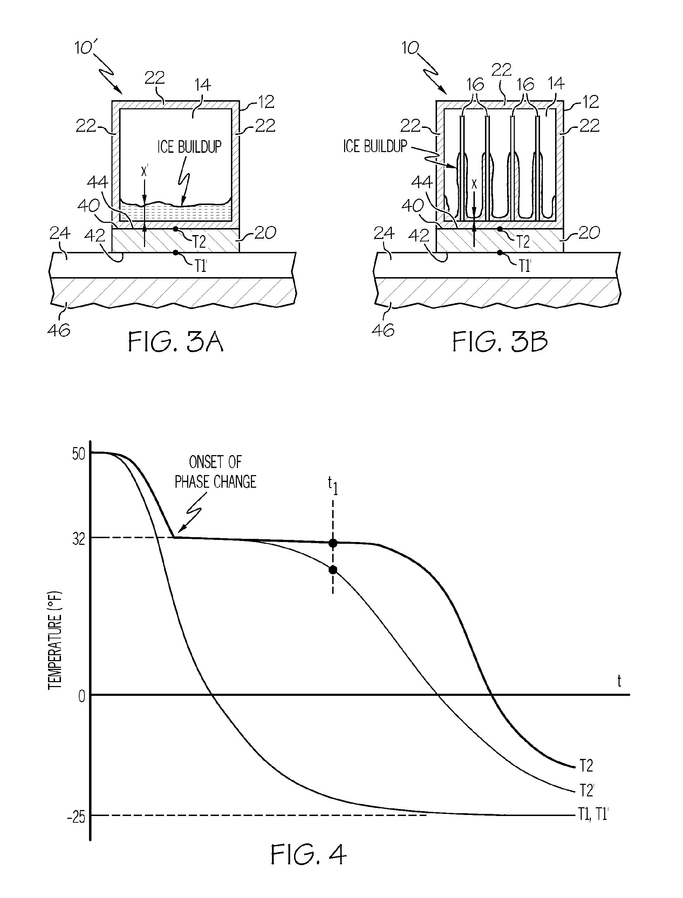

Referring initially to FIGS. 1-3, illustrative energy harvesting devices are generally indicated by reference numerals 10 when fins 16 are present and 10' when fins are absent. The energy harvesting devices 10, 10' are adapted to generate electrical power from a thermal differential or gradient. To accomplish this, the energy harvesting devices 10, 10' include a thermoelectric device 20 that is adapted to produce electricity according to a thermoelectric effect when a thermal gradient is imposed across the first and second major surfaces 40, 42 thereof (see FIG. 3) by exposure of at least one of the major surfaces 40, 42 to a temperature variation. As used herein, the term "thermoelectric effect" encompasses the Seebeck effect, the Peltier effect, and the Thomson effect, which in many textbooks is referred to as the Peltier-Seebeck effect.

The temperature variation that the thermoelectric device 20 is exposed to may be a result of the mobility of a substrate 24 to which the thermoelectric device 20 is thermally conductively mounted. In one embodiment, the substrate 24 may be part of a mobile vehicle such as an aircraft. The substrate 24 may be an aircraft wall that will experience a temperature change during take off, flight, and/or landing. Generally, the aircraft wall includes an interior panel, an outer aircraft skin, and a wall space between the interior panel and the aircraft skin. The energy harvesting device 10 may be thermally conductively mounted to any one of these layers.

An aircraft may experience a temperature change from ambient air temperature on the ground to about -28°C during flight. Temperature variations may also exist at other aircraft structural components, for example, but not limited to hydraulic lines (typically temperatures of about 20°F to about 200°F above ambient temperature), engines, PAC bleed air ducts (typically at temperature of about 490°F), during ground operations, or while the aircraft is parked. Any of these temperature variations may be taken advantage by the energy harvesting devices 10, 10' as long as the materials selected for the device's construction will not degrade, react, or fail at such temperatures. The devices 10, 10' should also be capable of harvesting energy during a phase change transition at some commonly experienced mid-range temperature.

While an aircraft is used as an example of a mobile vehicle to which the energy harvesting devices 10 may be mounted, "mobile vehicle" is not limited thereto. The mobile vehicle may be a ship, submarine, automobile, train, projectile, balloon, animal, or spacecraft.

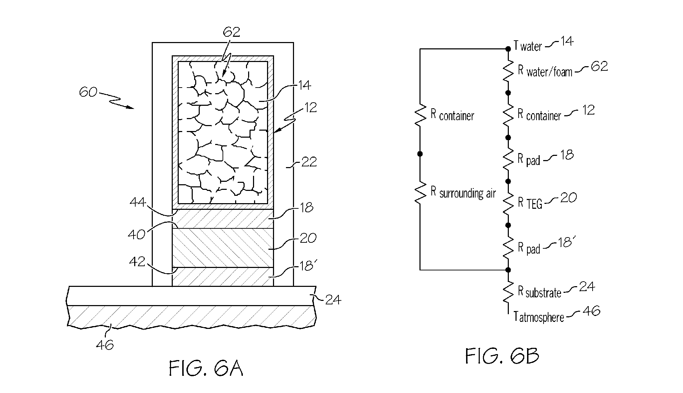

The energy harvesting devices 10 as shown in FIGS. 1-2 include a first thermally-conductive layer 18 disposed in thermal contact with the first major surface 40 of a thermoelectric device 20 and includes a housing 12 disposed in thermal contact with the first thermally conductive layer 18 opposite the thermoelectric device 20. The housing 12 encloses a phase change material (PCM) 14. This construction enables thermal communication between the phase change material and the thermoelectric device such that electrical power can be generated. Within energy harvesting devices 10, fins 16 are present within housing 12 for contact with the PCM 14. The energy harvesting devices 10 may include insulation 22 surrounding the housing 12 and the TEG 20 as illustrated in FIG. 6. Insulation 22 is advantageous because it minimizes heat loss through the surrounding air and maximizes the duration of phase change and power generation. In one embodiment, as shown in FIG. 1, the energy harvesting device 10 may be electrically coupled to a boost device 26 and/or a radio transmitter 30 that is capable of transmitting signals. Each of the various components of the energy harvesting devices 10, 10' are discussed in more detail below.

The thermoelectric device 20 may be any known and/or commercially available device such as a Thermoelectric Generator or the like available from Hi-Z Technology, Inc., EnOcean GmbH, and/or Micropelt GmbH. In one embodiment, the thermoelectric device 20 may include a BiSn junction on an alumina ceramic material. One aspect of the energy harvesting devices 10, 10' is to miniaturize the devices. Accordingly, the thermoelectric device 20 is as small as possible and may be at most about 2.5 mm x 3.3 mm x 1.1 mm. In another embodiment, the thermoelectric device 20 may be at most about 3.4 cm x 3.0 cm x 1.0 cm.

To enhance thermal conductivity between the thermoelectric device 20 and the surfaces its two major surfaces 40, 42 contact, thermally conductive layers 18, 18' may be present thereagainst. As shown in FIGS. 1-2, the first thermally conductive layer 18 may be present between the thermoelectric device 20 and the housing 12 of the PCM 14 and the second thermally conductive layer 18' may be present between the substrate 24 and the thermoelectric device 20. The first and second thermally conductive layers 18, 18' may be a layer of material having high thermal conductivity, good gap-filling capability, good dielectric properties, low contact stresses and long-term reliability. In one embodiment, the thermally conductive layers 18, 18' may be a thermally conductive interface pad such as those available from 3M and/or Laird Technologies. The pad may be from about 0.5 mm to 7 mm thick. In one embodiment, the pad is about 1 mm to about 5 mm thick. In another embodiment, the thermally conductive layers 18, 18' may be a thermal interface material such as a phase change thermal interface material that softens and fills tiny gaps at operating temperature or a thermally conductive grease, which conforms to irregularities in the mating surfaces, such as those available from Laird Technologies. In another embodiment, the first and second thermally conductive layers 18, 18' may be a thermal compound or a thermal adhesive, such as those available from Arctic Silver.

Still referring to FIGS. 1-2, housing 12 may be constructed of any thermally-conductive material. The housing 12 should also be durable enough to withstand frequent changes in the PCM's volume as phase change occurs, restrict passage of the PCM through the walls (so the materials will not dry out or water-out if the material is hygroscopic), and resist leakage and corrosion. Suitable thermally-conductive materials include, but are not limited to, metal, metal-impregnated plastic, and thermally-conductive carbon. In one embodiment, the housing 12 may be copper or stainless steel. In another embodiment, the housing 12 may be or include a polypropylene or polyolefin polymer.

Referring now to FIG. 3, in another embodiment, only the face of the housing 44 in thermal contact with the thermoelectric device 20 may be constructed of a thermally conductive material while all other faces are not. Thus, these other faces may serve as a thermal insulation 22, as discussed in more detail below. Side 44 is in thermal communication with the thermoelectric device 20 and is preferably sized and/or shaped to match the dimensions of the thermoelectric device 20 to maximize the thermal conductivity therebetween. The housing 12 is not limited to any particular shape or size. In one embodiment, housing 12 may be a cube as illustrated in FIGS. 1-3.

In an alternate embodiment as shown in FIG. 6, the energy harvesting device, generally designated 60 in FIG. 6, includes housing 12 that may be or include an open-cell, conductive foam 62 for housing the PCM 14, insulation 22 surrounding the housing 12 except side 44 of the housing 12, which contacts a first thermally conductive layer 18 that is in thermal contact with a first major surface 40 of a thermoelectric device 20 having a second major surface 42 in thermal contact with a second thermally conductive layer 18' that is in thermal contact with a substrate 24 that may be exposed to the atmosphere 46. The PCM 14 can be contained within the cells of the foam 62 and sealed therein by a sealant, by the housing 12 or other enclosure means. In this embodiment, the foam 62 may be sized and/or shaped to match the dimension of the thermoelectric device 20 for maximization of thermal conductivity therebetween. The foam housing may be shaped similarly to the housing 12 described above and may substantially fill the cavity within housing 12 to maximize thermal communication between the foam 62, the PCM 14 and the thermoelectric device 20. The foam 62 may also be soldered, welded, brazed, bonded or otherwise joined to the face of the housing 12 in thermal contact with thermoelectric generator 20 to promote efficient heat transfer therebetween.

FIG. 6 also includes a thermal circuit diagram 64 for the energy harvesting device 60. The diagram illustrates the resistance of each component positioned between the PCM 14 and the atmosphere 46, which is providing a temperature variation to the substrate 24. The PCM 14 is water in the diagram and has a temperature designated as $T_{water}$. The atmosphere has a temperature designated as $T_{atmosphere}$.

In one embodiment, the open-cell, conductive foam is a carbon foam. The carbon foam may be a graphene foam. One examplary commercially available foam is KFOAM carbon foam, available from Thomas Golubic at Golubic-TA@koppers.com. KFOAM has highly ordered graphitic ligaments for high thermal conductivity greater than 100 W/m·K, similar to aluminum, but with one-fifth the density (density range of 0.35 - 0.60 g/cc) and has a coefficient of thermal expansion that is close to silicon. The open porosity of the carbon foam is about 75-80 percent. KFOAM has a compressive strength of 3.5 MPa, and is able to perform as a stand-alone material or bonded to other materials to enhance their properties. The carbon foam also has uniform density throughout that results in more consistent machining with less waste. Accordingly, KFOAM can easily be cut into various shapes and configurations.

The housing 12 may be capable of housing about one microliter up to about 1000 ml, more particularly a half a milliliter to about 20 ml of the PCM 14, but is not limited thereto. In one embodiment, the housing may house up to about 2 ml of a PCM 14.

Within the housing 12, as shown in FIGS. 1-3, fins 16 may be included that are in thermal communication with the PCM 14. The fins 16 may be positioned in various configurations within the housing 12 to provide a more uniform temperature throughout the PCM 14. The more uniform temperature provides higher voltages for superior energy harvesting performance as will be explained with reference to FIGS. 3-5.

FIG. 3 shows energy harvesting device 10' without fins and energy harvesting device 10 with fins side by side at a time when they are both at a steady state condition above freezing. As depicted in FIG. 3, a phase change material 14 (e.g. water) is contained in a container 12 in thermal contact with one side of a thermoelectric device 20 such as a thermoelectric generator (TEG). The other side of the TEG 20 is in thermal contact with a substrate 24 that is exposed to temperature fluctuations, such as those experienced by the structure or components of an aircraft.

By way of example here, the substrate 24 is part of an airplane structure. The substrate's temperature changes as it becomes exposed to portions of the atmosphere at various temperatures. For example, when an airplane climbs from one altitude to a substantially different altitude, the structure is exposed to different parts of the atmosphere that are typically colder at the higher altitudes and warmer at lower altitudes. Therefore, the structure's temperature will vary substantially. It may vary, for example, from 50°F when the airplane has been sitting at an airport to -25°F after it has climbed to a cruise altitude.

In this example, heat will transfer out of the water 14, through the container 12, TEG 20 and substrate 24 and into the atmospheric air 46. This loss of thermal energy out of the water 14 will eventually bring the water down to the freezing point, where it will go through a phase change, and then continue down to a temperature approaching that of the substrate (e.g. -25°F in this example).

FIG. 3 defines temperatures of interest within the two energy harvesting devices 10, 10'. Temperatures T1 and T1' are at the surface interface between the substrate 24 and the TEG 20. T2 and T2' are at the surface interface between the TEG 20 and the container 12. In this example, we will assume that the fins 16 in energy harvesting device 10 are very thin and displace an insignificant amount of water 14. Thus the volume and mass of the two devices 10, 10' are very similar.

FIG. 4 graphically illustrates how these temperatures, T1, T1', T2, T2', will typically vary over the course of the airplane ascent described above. As the airplane ascends through the atmosphere, the temperature of the structure will drop rapidly and eventually reach a near steady state temperature well below freezing (shown as -25°F in this example). This is illustrated by curves T1 and T1', which are substantially similar. Temperatures T2 and T2' will also start to drop rapidly, but with some lag time as heat conducts out of the water 14, through the TEG 20 and into the structure. However, upon reaching the freezing point of -32°F, these temperatures will stabilize at the onset of phase change, not withstanding the potential for a period of supercooling of the water.

This onset of phase change is where the two devices 10, 10' begin to differ. The water in device 10' will start to solidify from the coldest surface first, which is the surface nearest the TEG 20 since this is the surface from which heat is being more significantly lost. As ice builds on this surface, the solid ice is capable of supporting a temperature gradient through its thickness, x', with its surface at the liquid/solid interface at freezing (-32°F) and its surface closest to the generator now at some temperature below freezing. Thus, the temperature gradient across the TEG 20 of device 10' ($\Delta$T'=T2'-T1') begins to decline.

In device 10, the internal fins 16 are able to draw heat deeper within the phase change material 14. Thus, the buildup of the solid phase of the PCM (ice for this example) will be spread over the larger surface area of the fins 16 and be substantially thinner, x, than the thickness, x', of the ice in device 10'. The thinner ice build-up of device 10 will support a smaller temperature gradient, thus allowing temperature T2 to be higher than T2' at the surface of the TEG 20. This higher temperature in device 10 provides a higher temperature gradient across the TEG 20 thereof ($\Delta$T=T2-T1 > $\Delta$T'=T2'-T1'). As shown in FIG. 4, at time $t_1$ temperature T2 is higher than T1.

TEGs 20 provide voltages that are proportional to the temperature gradient across their surfaces. Accordingly, the voltages in device 10 will be higher than the voltages in device 10', thus providing superior performance.

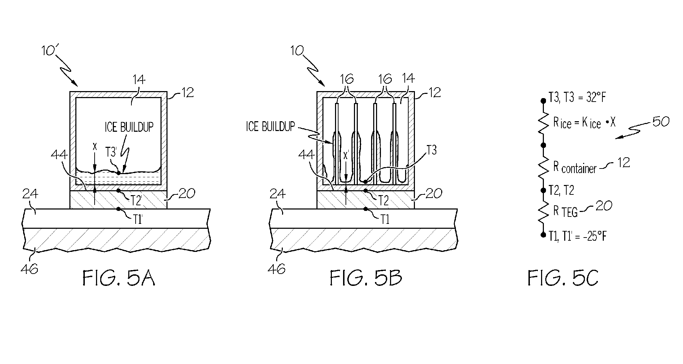

Energy harvesting device 10 has additional thermal advantages over device 10' as shown by the thermal circuit diagram 50 in FIG. 5 and equation (1) below.

$$\Delta T_{TEG} = (T3 - T1)\left(\frac{R_{TEG}}{R_{TEG} + R_{container} + K_{ice} \cdot x}\right) \qquad (1)$$

Given that T3,T3' = 32°F, T1,T1' = -25°F and that $R_{container}$ and $R_{TEG}$ are the same in both designs, $R_{ice}$ is the only variable governing the temperatures at T2 and T2'. As $R_{ice}$ is proportional to thickness x, device 10 will clearly produce a higher temperature gradient across the TEG than device 10', given the relationship

$$\Delta T_{TEG} = (32 - (-25))\left(\frac{R_{TEG}}{R_{TEG} + R_{container} + K_{ice} \cdot x}\right). \qquad (2)$$

The fin 16 as shown in FIG. 1-2 may be a single generally spiraling coil of conductive material. In another embodiment, the fin 16 may comprise a plurality of spiraling coils of conductive material. In an alternate embodiment, as shown in FIG. 3, the fins 16 may be a plurality of fingers of conductive material extending across at least a portion of the housing 12. One of skill in the art will appreciate that other fin configurations are possible and that the invention is not limited to these specific configurations.

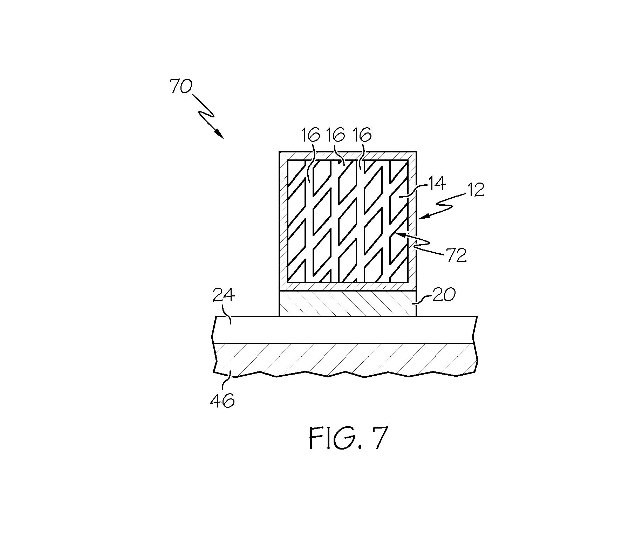

The fins 16 may be or include the same or a different conductive material as the housing 12. In one embodiment, the fins 16 may be of a construction that provides greater surface area for thermal contact with the PCM 14. In one embodiment, the fins 16 may be an open-cell, conductive foam 62 as shown in the energy harvesting device 60 of FIG. 6. One example of an open-cell, conductive foam is a carbon foam such as those described above. In another embodiment, the fins 16 may be a conductive mesh 72 as shown in the energy harvesting device 70 of FIG. 7, which contains other components as described above for FIGS. 1-3. The conductive mesh may be a network of conductive material that is machined, etched, molded or formed into a conductive material by other known techniques or the mesh may be microtrusses formed within the housing 12 using additive manufacturing techniques.

The phase change material 14 housed within the housing 12 of the energy harvesting device 10 and in contact with fins 16 may be any suitable phase change material for the temperature variation that will be experienced by the substrate 24. In one embodiment, the PCM 14 present in the energy harvesting device 10 is one that will respond to the temperature in the midrange of the thermal cycles experienced by the substrate 24 during the mobile vehicle's intended use. An advantage provided by the PCM 14 is that it extends the time of thermal differential across the TEG during surface temperature fluctuations so as to increase the amount of thermoelectric energy harvested. In one embodiment, the PCM 14 transitions from a liquid to a solid and from solid to liquid.

Water is one example of a PCM. Water requires a removal of 334 joules/gram to make the phase change from water to ice and conversely the addition of 334 joules/gram to change from ice back to water. In one embodiment, another PCM may be mixed with the water.

Other suitable PCMs include organic PCMs such as but not limited to lauric acid, trimethylolethane (about 37 wt% water), heptanone-4, n-undecane, TEA-16, ethylene glycol, n-dodecane, thermasorb 43, thermasorb 65, sodium hydrogen phosphate, thermasorb 175+, and thermasorb 215+ and inorganic PCMS such as but not limited to Mn$(NO_3)_2$·6HOH + $MnCl_2$·4HOH, sodium silicate, zinc, aluminum. The PCM may also be a metallic PCM including binary and ternary eutectic systems. Some example metallic PCMs are present in Table 1 below.

Table 1

| Eutectic | ΔHf (kJ/kg) | Te (K) | ΔHf / Te (kJ/kg·K) |
|---|---|---|---|
| Al-Si | 515 | 851 | 0.605 |
| Al-Ge | 368 | 712 | 0.532 |
| Mg-Si | 774 | 1219 | 0.635 |
| Mg-Ge | 496 | 969 | 0.511 |
| Al-Si-Mg | 545 | 833 | 0.654 |
| Si | 1800 | 1687 | 1.067 |
| Be-Si | 1350 | 1363 | 0.990 |
| Ca-Si | 1100 | 1296 | 0.849 |

As TEGs 20 in the energy harvesting devices 10, 10' typically produce relatively low voltages, a voltage boosting circuit 26 may be electrically coupled to the energy harvesting devices 10, 10' to produce a voltage useful for the electrical load of a selected end device. Experimentation shows, for example, that typical TEG's as used in the above described energy harvesting devices 10, 10' produce on the order of 0.5 V open circuit. A voltage boosting circuit 26 can boost the voltage to something on the order of 4.5 V. 4.5 V is sufficient to charge small batteries or a capacitor as part of a wireless sensor node. The voltage boosting circuit's efficiency is often related to its input voltage (everything else being equal); accordingly, device 10 of FIGS. 3 and 5 is again superior over device 10' in producing total output power through this circuit ($P_{device\ 10} > P_{device\ 10'}$). The voltage boosting circuit 26 may be a commercially available voltage booster such as an EnOcean® voltage booster available from EnOcean GmbH.

The higher temperature gradient across the TEG 20 results in an increase in the voltage produced by the energy harvesting device 10. Accordingly, the presence of the conductive fin(s) and, optionally, the voltage boosting circuit may increase the overall energy generated by the TEG 20 by about 20 to about 40 %.

In one embodiment, the voltage boosting circuit 26 may be electrically coupled to a radio transmitter 30. The radio transmitter may include an energy storage device 32 such as a capacitor to store energy from the voltage boosting circuit 26. The energy stored within the radio transmitter 30 that ultimately came from the energy harvesting device 10, 10' may be sufficient to trigger multiple transmission from the radio transmitter to send signals 38.

Instead of radio transmitter 30, an independent energy storage device (not shown) may be electrically connected to the thermoelectric device 20 to receive and/or store the electrical power therefrom. The stored electrical power can be used to power various electrical devices such as dimming windows or sensors. In another embodiment, the thermoelectric device 20 or the voltage boosting circuit 26 may be directly connected to an electrical device for powering that electrical device, which is typically through wiring. In typical applications, energy harvesting devices 10 are provided in multiple locations on mobile device (e.g., throughout the fuselage of an aircraft) to ensure an adequate supply of electrical power to the chosen electrical device or devices.

In one embodiment, the electrical device that is the ultimate recipient of the power from the energy harvesting device 10 is a sensor. The sensor may be a wireless sensor; thus, the presence of the radio transmitter 30 is required. Wireless sensors are particularly useful in the wing, tail or landing gear bay of an aircraft, where the addition or retrofit of wires would be difficult. For example, the energy harvesting device 10 is well-suited to flight test or health monitoring applications to report the position of an actuator or temperature of a surface without the need to extend a length of wiring to the monitored device. Energy levels as low as 50 joules per flight cycle could be useful to sustain the lowest-power wireless sensors. An example sensor may be one that wakes once per hour or upon a triggering event, samples a sensor transducer, and logs the data in non-volatile memory for later retrieval.

The embodiments of this invention described in detail and by reference to specific exemplary embodiments of the energy harvesting device and methods are within the scope of the appended claims. It is contemplated that numerous other modifications and variations of the energy harvesting device and methods may be created taking advantage of the disclosed approach. In short, it is the applicants' intention that the scope of the patent issuing herefrom be limited only by the scope of the appended claims.

## Claims

1. An energy harvesting device comprising:

   a thermoelectric device adapted to produce electricity according to a Seebeck effect when a thermal gradient is imposed across first and second major surfaces thereof;
   a housing enclosing a phase change material, the housing being disposed for thermal communication with the first major surface of the thermoelectric device; and
   a radio transmitter electrically coupled to the thermoelectric device, the radio transmitter capable of transmitting signals to a wireless receiver.

2. The energy harvesting device of claim 1 further comprising a first thermally-conductive layer disposed between the housing and the first major surface of the thermoelectric device.

3. The energy harvesting device of claim 2 further comprising a second thermally-conductive layer disposed in thermal contact with the second major surface of the thermoelectric device, the second thermally-conductive layer being capable of being disposed in thermal contact with a medium experiencing a temperature change.

4. The energy harvesting device of claim 1 wherein the housing is or includes a thermally conductive, open-cell foam, and the phase change material is enclosed with the open-cells thereof.

5. The energy harvesting device of claim 1 wherein the housing includes at least one conductive fin therein to provide a more uniform distribution of heat to the phase change material.

6. The energy harvesting device of claim 5 wherein the conductive fin is generally a spiraling coil of conductive material contained within the housing.

7. The energy harvesting device of claim 1 wherein the phase change material is or includes water.

8. The energy harvesting device of claim 1 further comprising a voltage boost device in electrical communication between the thermoelectric device and the radio transmitter.

9. The energy harvesting device of claim 2 wherein the thermoelectric device, the housing, and the first and second thermally conductive layers define a unit that is about a 0.25 cm to 1.0 cm x 0.25 cm to 5.0 cm x 5.0 cm to 5.0 cm cube.

10. The energy harvesting device of claim 9 wherein the unit is at least partially surrounded by an insulating layer.

11. An energy harvesting device comprising:

   a thermoelectric device adapted to produce electricity according to a Seebeck effect when a thermal gradient is imposed across first and second major surfaces thereof;

a housing enclosing a phase change material, the housing being disposed for thermal communication with the first major surface of the thermoelectric device; and

a conductive fin within the housing to provide more uniform distribution of heat to the phase change material.

12. The energy harvesting device of claim 11 further comprising a first thermally-conductive layer disposed between the housing and the first major surface of the thermoelectric device.

13. The energy harvesting device of claim 12 further comprising a second thermally-conductive layer disposed in thermal contact with the second major surface of the thermoelectric device, the second thermally-conductive layer being capable of being disposed in thermal contact with a medium experiencing a temperature change.

14. The energy harvesting device of claim 11 wherein the conductive fin is generally a spiraling coil of conductive material contained within the housing.

15. The energy harvesting device of claim 11 wherein the conductive fin is a mesh network of conductive material.

FIG. 1

FIG. 2

FIG. 3A

FIG. 3B

FIG. 4

FIG. 5A

FIG. 5B

FIG. 5C

FIG. 6A

FIG. 6B

70

16 16 16

14

12

72

24

20

46

FIG. 7